# EUROPEAN PATENT SPECIFICATION

(11) **EP 2 137 586 B1**
(45) Date of publication and mention of the grant of the patent: **08.05.2013**
(21) Application number: 08731208.8
(22) Date of filing: 03.03.2008
(51) Int. Cl.: G05D 16/20

(54) **PRESSURE CONTROL FOR VACUUM PROCESSING SYSTEM**
DRUCKSTEUERUNG FÜR VAKUUMBEARBEITUNGSSYSTEM
RÉGULATION DE PRESSION POUR SYSTÈME DE TRAITEMENT À VIDE

(30) Priority: 06.03.2007 US 714440
(43) Date of publication of application: 30.12.2009
(73) Proprietor: MKS Instruments, Inc., Andover, MA 01810 (US)
(72) Inventor: CHAMBERLAIN, David, Hooksett, NH 03106 (US); GOLDMAN, David, J., North Andover, MA 01845 (US); HILL, Gordon, Arlington, MA 02474 (US)
(74) Representative: Hill, Justin John
(86) International application number: PCT/US2008/055610
(87) International publication number: WO 2008/109496

(56) References cited:
- WO-A-2006/119319
- WO-A-2007/109038
- US-A1- 2007 235 668

## Description

**BACKGROUND**

Pressure controllers for processing tools, such as semiconductor processing tools, typically perform pressure control in one or more vacuum chambers in the tool so, in response to measurements of the actual pressure. Currently, analog communication links are used to communicate pressure signals between these pressure controllers and the pressure sensors that actually perform the pressure measurements. Also digital communication is used, see e.g. WO 2006/119319.

When analog communication links or known digital links are used to transmit pressure signals, filtering is required at the receiving end of the signal. This reduces the bandwidth of the system, which in turn can limit pressure control performance, in particular in vacuum systems with a fast time constant. Noise due to non-ideal grounding can also be a problem when analog signals are exchanged between the pressure sensor and the pressure controller in a pressure control system.

There is a need for pressure control systems and methods that can avoid these adverse effects.

**SUMMARY**

A pressure control system for a tool includes a digital communication network between a pressure sensor and a pressure controller. The digital communication network is configured to communicate signals between the pressure sensor and the pressure controller. The pressure sensor is configured to measure pressure within a vacuum chamber in the tool. The pressure controller is responsive to pressure measurements, made by the pressure sensor and communicated to the pressure controller through the digital communication network, to control the pressure within the vacuum chamber so as to maintain the pressure in the vacuum chamber at a pressure set point received from the tool.

A method of controlling pressure in a vacuum chamber in a tool may include: measuring pressure in the vacuum chamber, receiving from the tool a pressure set point for the vacuum chamber, and communicating the pressure measurement and the pressure set point to a pressure controller through a digital communication network. The method may further include controlling the pressure in the vacuum chamber in response to the received pressure measurement and pressure set point, so as to maintain pressure in the vacuum chamber at the pressure set point.

**BRIEF DESCRIPTION OF THE DRAWINGS**

FIG. 1 illustrates a pressure control system that controls pressure in a vacuum processing chamber by using a digital network to communicate pressure signals between a pressure sensor and a pressure controller, in accordance with one embodiment of the present disclosure.

FIG. 2 illustrates a pressure control system that controls pressure in a vacuum processing chamber by using a digital network to communicate pressure signals between a pair of pressure sensors and a pressure controller, in accordance with another embodiment of the present disclosure.

**DETAILED DESCRIPTION**

Systems and methods for vacuum pressure control are disclosed in which a digital communication link is provided between a pressure sensor that makes measurements of pressure, and a pressure controller that controls the pressure to a desired set point in response to these pressure measurements. By using a digital communication link to communicate pressure signals between the pressure sensor and the pressure controller, immunity may be acquired from ground noise that is often present in systems such as semiconductor processing tools, and that would adversely affect pressure control. Further, the effective dynamic range for the pressure measurement and control may be increased.

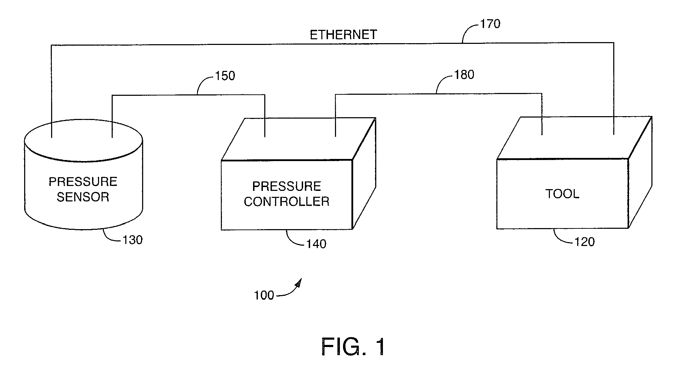

FIG. 1 illustrates a pressure control system 100 that controls pressure in a tool 120, by using a digital communication network 150 to communicate pressure signals between a pressure sensor 130 and a pressure controller 140, in accordance with one embodiment of the present disclosure. The tool 120 may be a semiconductor processing tool, by way of example, but other types of processing tools are also within the scope of the present disclosure.

The digital communication network 150 may be a bi-direction (or two-way) network that enables two-way communication of pressure-related signals and messages between the pressure sensor 130 and the pressure controller 140. Alternatively, the communication network 150 may be a one-way network, in which pressure-related communications may occur along one direction only, while transmissions along the other direction are reserved solely for housekeeping functions such as zeroing and error status.

The pressure sensor 130 measures pressure within one or more vacuum chambers in the tool 120. The pressure sensor 130 may be a capacitance-based pressure transducer, in one embodiment of the present disclosure, although other types of pressure transducers are also within the scope of the present disclosure. For example, the pressure sensor 130 may be a baratron manufactured by MKS Instruments, Inc.

The pressure controller 140 receives from the pressure sensor 130, through the digital communication network 150, signals containing the pressure measurements by the pressure sensor 130. The pressure controller 140 also receives desired pressure set points from the tool 120, typically sent by a tool controller (not shown) within the tool 120. In response to the received pressure measurement signals and pressure set points, the pressure controller 140 controls pressure in the vacuum chamber(s) in the tool 120 so as to maintain the pressure at the desired pressure set points received from the tool 120. Typically, the pressure controller 140 includes a valve that opens and closes so as to control the flow rate of fluid into or out of the vacuum chamber and thereby controlling the pressure in the vacuum chamber.

The digital communication network 150 enables closed loop sensor feedback for pressure control by the system 100. The digital communication network 150 may be a private network, such as CAN (Control Area Network) by way of example. Private digital networks generally allow for highly reliable packet transmission at regular, periodic intervals. It is desirable that the CAN network enable signal communication at an update rate of about 10 msec or higher.

For purposes of the pressure control system 100, it is desirable that the digital communication network 150 be an isolated network that can communicate signals with substantially no interference from any other networks and any other processes going on in these networks. In this way, the digital communication network 150 would be able to deterministically transmit signals that are substantially noise-free.

While an isolated and private digital communication network 150 such as a CAN may be desirable, in some embodiments the digital communication network 150 may include one or more of the following: Ethernet TCP (Transmission Control Protocol)/IP (Internet Protocol); DeviceNet; CAN (Controller Area Network); UDP/IP (User Datagram Protocol / Internet Protocol); RS (Recommended Standard)-232; and RS (Recommended Standard)-485.

The pressure controller 140 may receive control signals (such as the pressure set point) from the tool 120 over a tool level communication link 180. This link 180 may be implemented using systems that may include, but are not limited to: Dnet; RS232; and Ethernet.

Communications between the pressure sensor 130 and the tool 120 may also occur over a separate tool level communication link 170. While FIG. 1 illustrates this network 170 as an Ethernet, communication networks other than the Ethernet may be used implement the tool level communication link 170. Typically, signals relating to system diagnostic information may be communicated through the tool level link 170.

These signals may contain information and/or commands that include, but are not limited to, the following: calibration and/or zeroing of the pressure sensor 130; dynamic range of the pressure sensor 130; and diagnostic information for the pressure control system 100. Diagnostic information may relate to factors that include, but are not limited to: heater temperature of the pressure sensor; shorting of a diaphragm in the pressure sensor 130; internal failure of the pressure sensor 130; cumulative drift of the pressure sensor 130; zeroing range of the pressure sensor; and the exceeding of the full scale range by the pressure sensor 130.

The closed loop sensor feedback system described above may also be configured to support additional sensor input, in addition to supporting input from the pressure sensor 130. For example, the pressure control system 100 may be configured to receive the output from an FRC (flow ratio controller) that provides a flow change feedforward signal to the pressure controller 140.

Signals other than pressure measurement signals, for example diagnostics information described above, could also be communicated between the pressure sensor 130 and the pressure controller 140 through the digital communication network 170, in one embodiment of the present disclosure.

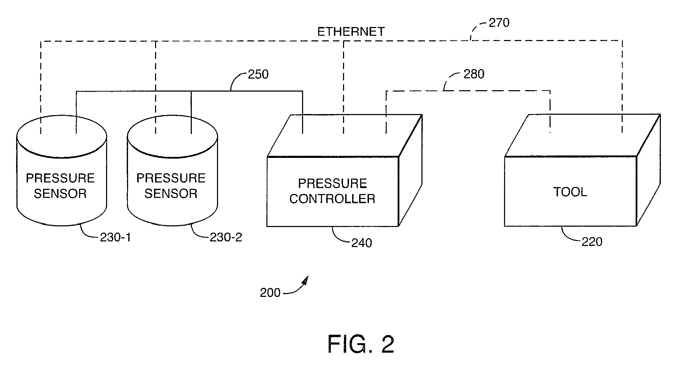

FIG. 2 illustrates a pressure control system 200 that controls pressure in one or more vacuum processing chambers in a tool 220, in accordance with another embodiment of the present disclosure. The embodiment illustrated in FIG. 2 works in the same way, compared to the embodiment illustrated in FIG. 1, except that in the system 200, a digital network 250 is used to communicate pressure signals between a pair of pressure sensors (illustrated as 230-1 and 230-2) and a pressure controller 240. While just two sensors have been illustrated in FIG. 2, in general the number N of pressure sensors that can be connected to the digital network 250 may be variable, i.e. the user may have the flexibility of adding/removing desired numbers ofpressure sensors 230-1, 230-2, ..., 230-i from the digital network 250.

In an embodiment in which the digital communication network is a CAN network, the packet transmission for signals containing pressure measurement, diagnostics, and other information, may occur in one or more ways, as described below.

In one example, the pressure sensor(s) may send out a message to the pressure controller. An exemplary protocol may technically consist of a CAN Group 1 message ID 0, broadcast from the pressure sensors every 10ms. The message identifier may be an unsigned long, with the lowest six bits being the MacID of the sending pressure sensor (illustrated as 230-1 and 230-2). All other bits, which are unused, may be set to zero. This may produce a group I message that should take priority over any normal (group 2) Devicenet communications if present. This may also assure that the arbitration between the pressure sensor's messages will be handled by a lower level driver without additional work.

In this example, a packet in the message may contain a message ID, a data length of 9, followed by the data itself. The reading in Torr may be represented as a four byte floating point number. The full scale in Torr may be represented as a four byte floating point number. The status may be represented as an eight bit unsigned integer.

The status indicator bits may include, but are not limited to, the following:

0) heater at control temperature;

1) pressure within zeroing range;

2) diaphragm shorted;

3) e-Baratron over 110% of full-scale range;

4) zero adjustment over 20% (further zeroing not allowed);

5) e-Baratron internal failure (for reasons such as heater circuit failure, and power supply out of spec);

6) cumulative drift out of range; and

7) unused at this time.

0 & 1 bits may be required for zeroing.

DeviceNet drivers at the pressure control valve may be modified to disable normal MacID filtering. Messages that don't have the valve's MacID may normally be dropped when received. In this example, messages with other MacIDs are readings from the baratrons. The MacIDs are used to determine which pressure sensor is the high range channel and which is the low. Messages with unused MacIDs are dropped. For example, defaults at the valve may be MacID 1 for low channel, and MacID 2 for high channel. These values can be changed in the valve and on the pressure sensors.

Data may be read on the pressure control valve and used instead of reading the ADC (analog-to-digital converter). The ADC calibration data may be used to convert Torr pressure/range readings into simulated ADC raw counts.

The full scale range may be updated automatically if the valve's range for a transducer does not match the contents of a packet. The crossover point may also be adjusted appropriately.

In another situation, a message may be generated by a valve in the pressure controller 140, for example to initiate zeroing of one or more of the pressure sensors. The message identifier may be an unsigned long, with the lowest six bits being the commanded baratron's MacID. Bit 6 may be set to 1 but all other (unused) bits may be set to zero. This produces a group 1 message ID 1. The pressure sensor with the MacID that matches the message may do a zero. A default target value of 0% may be provided even if a traditional zero (0% assumed) is needed.

In this example, the message packets may contain a message ID, a data length of 4, then the data itself. The zero target may be represented in percent of full scale as a four byte floating point number.

In the above example, commands to be added to the baratron's interface may include, but are not limited to:

Enter digital baratron mode;

Get/Set MacID of baratron;

Commands to be added to the control valve's serial interface may include, but are not limited to:

Enter digital baratron mode;

Get/Set MacID of high or low channel pressure sensor;

Report status of high or low channel pressure sensor; and

Execute zero on high or low channel pressure sensor with or without a target.

In sum, systems and methods have been described in which a digital communication link is provided between one or more pressure sensors and a pressure controller, so that noise-free and high dynamic range signals are provided between the pressure sensors and the pressure controller, at an update rate of 10 msec or higher. The digital communication link allows improved pressure control stability and dynamic range.

While certain embodiments have been described of systems and methods for controlling pressure in the vacuum processing system, it is to be understood that the concepts implicit in these embodiments may be used in other embodiments as well. The protection of this application is limited solely to the claims that now follow.

## Claims

1. A pressure control system, comprising: a pressure sensor (130) configured to measure pressure within a vacuum chamber in a processing tool (120) ; a pressure controller (140) configured to control the pressure within the vacuum chamber; **characterized by**;
a digital, private, communication network (150) between the pressure sensor (130) and the pressure controller (140) configured to provide closed loop sensor feedback including transmission of pressure measurement signals from the sensor (130) to the controller (140) substantially free of interference from any other networks,
a first tool level communication link (180), separate and isolated from the communication network (150), configured to provide set point signals from the tool (120) to the controller (140); and
a second tool level communication link (170), separate and isolated from the communication network (150) and separate from the first tool level communication link (180), configured to provide system diagnostic information between the tool and the sensor; wherein the pressure controller is responsive to pressure measurements made by the pressure sensor and communicated to the pressure controller through the digital communication network, to control the pressure within the vacuum chamber so as to maintain the pressure in the vacuum chamber at a pressure set point received from the processing tool.

2. The pressure control system of claim 1, wherein the private digital communication network (150) is configured to communicate the signals through packet transmission occurring at periodic time intervals.

3. The pressure control system of claim 1, wherein the private digital communication network (150) is configured to deterministically transmit signals that are substantially free of noise.

4. The pressure control system of claim 1, wherein the processing tool (120) comprises a semiconductor processing tool.

5. The pressure control system of claim 1, wherein the second tool level communication link (170) is further configured to also communicate between the pressure sensor and the pressure controller signals relating to at least one of: calibration and zeroing of the pressure sensor; and dynamic range of the pressure sensor.

6. The pressure control system of claim 1, wherein the diagnostic information relates to at least one of: heater temperature of the pressure sensor; shorting of a diaphragm in the pressure sensor; internal failure of the pressure sensor; cumulative drift of the pressure sensor; zeroing range of the pressure sensor; and exceeding of full scale range by the pressure sensor.

7. The pressure control system of claim 1, wherein the private, digital communication network (150) is configured to communicate the signals at a signal update speed of about 10 msec or higher.

8. The pressure control system of claim 1, wherein the private, digital communication network (150) comprises at least one of: Ethernet TCP (Transmission Control Protocol)/IP (Internet Protocol); DeviceNet; CAN (Controller Area Network); UDP/IP (User Datagram Protocol / Internet Protocol); RS (Recommended Standard)-232; and RS (Recommended Standard)-485,

9. The pressure control system of claim 1, wherein the pressure sensor (130) comprises a capacitance-based pressure transducer.

10. The pressure control system of claim 1, further comprising a mass flow meter coupled to the private, digital communication network (150), the mass flow controller configured to measure flow rate of fluid into and out of the vacuum chamber and to transmit to the pressure controller signals representing the measured flow rate.

11. The pressure control system of claim 1, wherein the private, digital communication network (150) comprises at least one of: a one-way communication network configured to communicate pressure-related signals along a single direction; and
a bi-directional communication network configured to transmit pressure-related signals along two opposite directions.

12. The pressure control system of claim 1, further including a plurality N of pressure sensors coupled to the private digital communication network and the second tool level communication link (170), each of the plurality of pressure sensors configured to measure pressure within a vacuum chamber in a processing tool.

13. The pressure control system of claim 12, wherein the number N of pressure sensors is variable.

14. The pressure control system of claim 12, wherein the private digital communication network is configured to communicate the signals between the sensor and the controller through packet transmission occurring at periodic time intervals.

15. A system comprising: a tool including a vacuum processing chamber, a pressure sensor (130) configured to measure the pressure within said vacuum chamber, a pressure controller (140) configured to control the pressure within said vacuum chamber, and a tool controller configured to generate tool control signals including at least one signal that provides a pressure set point for the vacuum processing chamber; **characterized by**;
a digital, private, communication network (150) between the pressure sensor (130) and the pressure controller (140) configured to provide closed loop sensor feedback including transmission of pressure measurement signals from the sensor (130) to the controller (140) substantially free of interference from any other networks,
a first tool level communication link (180), separate and isolated from the communication network (150), configured to provide set point signals from the tool (120) to the controller (140); and
a second tool level communication link (170), separate and isolated from the communication network (150) and separate from the first tool level communication link (180), configured to provide system diagnostic information between the tool and the sensor; wherein the pressure controller is responsive to pressure measurements made by the pressure sensor and communicated to the pressure controller through the digital communication network, to control the pressure within the vacuum chamber so as to maintain the pressure in the vacuum chamber at a pressure set point received from the processing tool.

16. A method of communicating among a vacuum chamber of a tool, a pressure sensor (130) and a pressure controller (140) so as to control pressure in the vacuum chamber in the tool, the method **characterized by**:
measuring pressure in the vacuum chamber and transmitting a pressure measurement signal over a private digital communication network (150);
receiving from the tool a signal representing a pressure set point for the vacuum chamber over a communication link separate and isolated from the private digital communication network;
the pressure controller controlling the pressure in the vacuum chamber in response to the received pressure measurement and pressure set point, so as to maintain pressure in the vacuum chamber at the pressure set point; and
providing system diagnostic information over a second private communication link (170) separate from the private digital communication link between the sensor and the tool.

## Patentansprüche

1. Ein Druckkontrollsystem bestehend aus einem Drucksensor (130) zur Messung des Drucks in einer Vakuumkammer eines Bearbeitungssystems (120) und einem Druckcontroller (140) zur Steuerung des Drucks in der Vakuumkammer, wobei das Druckkontrollsystem Folgendes umfasst:
ein privates digitales Kommunikationsnetzwerk (150) zwischen dem Drucksensor (130) und dem Druckcontroller (140), das Sensorrückkopplung mit geschlossenem Regelkreis bereitstellt und Druckmesssignale vom Sensor (130) an den Controller (140) überträgt, wobei die Übertragung im Wesentlichen frei von Störungen von anderen Netzwerken sind;
eine separat und isoliert vom Kommunikationsnetzwerk (150) angeordnete erste Kommunikationsverbindung am System (180), die Sollwertsignale vom System (120) an den Controller (140) überträgt; und
eine separat und isoliert vom digitalen Kommunikationsnetzwerk (150) und separat von der ersten Kommunikationsverbindung am System (180) angeordnete zweite Kommunikationsverbindung am System (170), die systemdiagnostische Informationen zwischen dem System und dem Sensor bereitstellt und wobei der Druckcontroller auf Druckmesswerte anspricht, die vom Drucksensor ausgehen und die über das private digitale Kommunikationsnetzwerk an den Druckcontroller übertragen werden, um so den Druck in der Vakuumkammer auf dem Niveau eines vom Bearbeitungssystem erhaltenen Drucksollwerts zu erhalten.

2. Das Druckkontrollsystem nach Anspruch 1, wobei das private digitale Kommunikationsnetzwerk (150) die Signale in regelmäßigen Abständen in Form von Datenpaketen überträgt.

3. Das Druckkontrollsystem nach Anspruch 1, wobei das private digitale Kommunikationsnetzwerk (150) deterministisch Signale überträgt, die im Wesentlichen frei von Störungen sind.

4. Das Druckkontrollsystem nach Anspruch 1, wobei das Bearbeitungssystem (120) ein Halbleiter-Bearbeitungssystem umfasst.

5. Das Druckkontrollsystem nach Anspruch 1, wobei die zweite Kommunikationsverbindung am System (170) weiterhin Signale zwischen dem Drucksensor und dem Druckcontroller überträgt, die sich auf mindestens eines der Folgenden beziehen: Kalibrierung und Rückstellung des Drucksensors; und Dynamikbereich des Drucksensors.

6. Das Druckkontrollsystem nach Anspruch 1, wobei sich die diagnostischen Informationen auf mindestens eines der Folgenden beziehen: Heizelementtemperatur des Drucksensors, Kurzschließen einer Membran im Drucksensor, internes Versagen des Drucksensors, kumulative Nullpunktverschiebung des Drucksensors, Nullstellbereich des Drucksensors und Überschreiten des Skalenbereichs durch den Drucksensor.

7. Das Druckkontrollsystem nach Anspruch 1, wobei das private digitale Kommunikationsnetzwerk (150) die Signale zu einer Signalaktualisierungsrate von ca. 10 ms oder mehr überträgt.

8. Das Druckkontrollsystem nach Anspruch 1, wobei das private digitale Kommunikationsnetzwerk (150) mindestens eines der Folgenden umfasst: Ethernet TCP (Transmission Control Protocol)/IP (Internet Protocol), DeviceNet; CAN (Controller Area Network), UDP/IP (User Datagram Protocol / Internet Protocol), RS (Recommended Standard)-232 und RS (Recommended Standard)-485.

9. Das Druckkontrollsystem nach Anspruch 1, wobei der Drucksensor (130) einen kapazitätsbasierten Druckwandler umfasst.

10. Das Druckkontrollsystem nach Anspruch 1, weiter bestehend aus einem mit dem privaten digitalen Kommunikationsnetzwerk (150) verbundenen Massendurchflussmessgerät zur Messung der Durchflussrate von Flüssigkeiten in der Vakuumkammer und zur Übertragung der die gemessene Durchflussrate darstellenden Druckcontrollersignale.

11. Das Druckkontrollsystem nach Anspruch 1, wobei das private digitale Kommunikationsnetzwerk (150) mindestens eines der Folgenden umfasst: ein Ein-Weg-Kommunikationsnetzwerk zur Übertragung von druckrelevanten Signalen in eine einzige Richtung und
ein Zwei-Weg-Kommunikationsnetzwerk zur Übertragung von druckrelevanten Signalen in zwei entgegengesetzte Richtungen.

12. Das Druckkontrollsystem nach Anspruch 1, weiter bestehend aus einer Vielzahl N von mit dem privaten digitalen Kommunikationsnetzwerk und der zweiten Kommunikationsverbindung am System (170) verbundenen Drucksensoren, wobei jeder der Vielzahl von Drucksensoren konfiguriert ist, um den Druck in einer Vakuumkammer in einem Bearbeitungssystem zu messen.

13. Das Druckkontrollsystem nach Anspruch 12, wobei die Zahl N von Drucksensoren variabel ist.

14. Das Druckkontrollsystem nach Anspruch 12, wobei das private digitale Kommunikationsnetzwerk die Signale zwischen dem Sensor und dem Controller in regelmäßigen Abständen in Form von Datenpaketen überträgt.

15. Ein System bestehend aus einem System mit einer Vakuumkammer, einem Drucksensor (130) zur Messung des Drucks in der besagten Vakuumkammer, einem Druckcontroller (140) zur Steuerung des Drucks in der besagten Vakuumkammer und einem Systemcontroller zur Erzeugung von Systemkontrollsignalen einschließlich von mindestens einem Signal, das einen Drucksollwert für die Vakuumkammer bereitstellt; wobei das System aus Folgendem besteht;
einem privaten digitalen Kommunikationsnetzwerk (150) zwischen dem Drucksensor (130) und dem Druckcontroller (140) zur Bereitstellung von Sensorrückkopplung mit geschlossenem Regelkreis einschließlich Übertragung von Druckmesssignalen vom Sensor (130) an den Controller (140), wobei die Übertragung im Wesentlichen frei von Störungen von anderen Netzwerken ist;
einer separat und isoliert vom Kommunikationsnetzwerk (150) angeordneten ersten Kommunikationsverbindung am System (180), die Sollwertsignale vom System (120) an den Controller (140) überträgt; und
einer separat und isoliert vom digitalen Kommunikationsnetzwerk (150) und separat von der ersten Kommunikationsverbindung am System (180) angeordneten zweiten Kommunikationsverbindung am System (170), die systemdiagnostische Informationen zwischen dem System und dem Sensor bereitstellt und wobei der Druckcontroller auf Druckmesswerte anspricht, die vom Drucksensor ausgehen und über das private digitale Kommunikationsnetzwerk an den Druckcontroller übertragen werden, um so den Druck in der Vakuumkammer auf dem Niveau eines vom Bearbeitungssystem erhaltenen Drucksollwerts zu erhalten.

16. Ein Verfahren für die Kommunikation zwischen einer Vakuumkammer eines Systems, einem Drucksensor (130) und einem Druckcontroller (140) zur Steuerung des Drucks in der Vakuumkammer des Systems, wobei das Verfahren durch Folgendes gekennzeichnet ist:
Messung des Drucks in der Vakuumkammer und Übertragung eines Druckmesssignals über ein privates digitales Kommunikationsnetzwerk (150);
Empfang eines einen Drucksollwert für die Vakuumkammer darstellenden Signals vom System über die separat und isoliert vom digitalen Kommunikationsnetzwerk angeordneten Kommunikationsverbindung;
Steuerung des Drucks in der Vakuumkammer durch den Druckcontroller in Erwiderung auf den erhaltenen Druckmesswert und Drucksollwert zur Beibehaltung des Drucks in der Vakuumkammer auf dem Niveau des Drucksollwerts; und
Bereitstellung von systemdiagnostischen Informationen über eine separat vom privaten digitalen Kommunikationsverbindung angeordnete zweite private Kommunikationsverbindung (170) zwischen dem Sensor und dem System.

## Revendications

1. Système de régulation de pression comprenant : un capteur de pression (130) pouvant mesurer la pression dans une chambre à vide d'un outil de traitement (120) ; un régulateur de pression (140) pouvant réguler la pression dans la chambre à vide ; **caractérisé par** :
un réseau de communication privé numérique (150) entre le capteur de pression (130) et le régulateur de pression (140), pouvant assurer un retour d'information de capteur en boucle fermée, comprenant la transmission de signaux de mesure de pression du capteur (130) au régulateur (140) essentiellement sans interférence de tout autre réseau ;
une première liaison de communication au niveau de l'outil (180), distincte et isolée du réseau de communication (150), pouvant fournir des signaux de consigne de l'outil (120) au régulateur (140) ; et
une deuxième liaison de communication au niveau de l'outil (170), distincte et isolée du réseau de communication (150) et distincte de la première liaison de communication au niveau de l'outil (180), pouvant fournir des informations de diagnostic de système entre l'outil et le capteur ; dans lequel le régulateur de pression réagit aux mesures de pression effectuées par le capteur de pression et communiquées au régulateur de pression sur le réseau de communication numérique, afin de réguler la pression dans la chambre à vide et maintenir ainsi la pression dans la chambre à vide au niveau d'une valeur de consigne de pression reçue de l'outil de traitement.

2. Système de régulation de pression selon la revendication 1, dans lequel le réseau de communication privé numérique (150) peut communiquer les signaux par transmission par paquets à des intervalles temporels réguliers.

3. Système de régulation de pression selon la revendication 1, dans lequel le réseau de communication privé numérique (150) peut transmettre de manière déterministe des signaux essentiellement sans parasite.

4. Système de régulation de pression selon la revendication 1, dans lequel l'outil de traitement (120) se compose d'un outil de traitement à semi-conducteur.

5. Système de régulation de pression selon la revendication 1, dans lequel la deuxième liaison de communication au niveau de l'outil (170) peut également communiquer, entre le capteur de pression et le régulateur de pression, des signaux concernant au moins l'un parmi : l'étalonnage et la remise à zéro du capteur de pression ; et la plage dynamique du capteur de pression.

6. Système de régulation de pression selon la revendication 1, dans lequel les informations de diagnostic concernent au moins l'un parmi : la température de réchauffeur du capteur de pression ; un court-circuit d'une membrane dans le capteur de pression ; une défaillance interne du capteur de pression ; une dérive cumulée du capteur de pression ; la plage de remise à zéro du capteur de pression ; et le dépassement de la plage complète par le capteur de pression.

7. Système de régulation de pression selon la revendication 1, dans lequel le réseau de communication privé numérique (150) peut communiquer les signaux à une vitesse de mise à jour de signal d'environ 10 ms ou plus.

8. Système de régulation de pression selon la revendication 1, dans lequel le réseau de communication privé numérique (150) se compose d'au moins un parmi : Ethernet TCP/IP (protocole de contrôle de transmission/protocole Internet) ; DeviceNet ; CAN (réseau local de commande) ; UDP/IP (protocole de datagramme utilisateur/protocole Internet) ; RS-232 (norme recommandée) ; et R-485 (norme recommandée).

9. Système de régulation de pression selon la revendication 1, dans lequel le capteur de pression (130) se compose d'un transducteur capacitif de pression.

10. Système de régulation de pression selon la revendication 1, comprenant en outre un détecteur de débit massique couplé au réseau de communication privé numérique (150), le détecteur de débit massique pouvant mesurer le débit de fluide entrant et sortant de la chambre à vide, et transmettre au régulateur de pression des signaux représentant le débit mesuré.

11. Système de régulation de pression selon la revendication 1, dans lequel le réseau de communication privé numérique (150) se compose d'au moins un parmi : un réseau de communication unidirectionnel pouvant communiquer des signaux concernant la pression dans une seule direction ; et
un réseau de communication bidirectionnel pouvant transmettre des signaux concernant la pression dans deux directions opposées.

12. Système de régulation de pression selon la revendication 1, comprenant en outre une pluralité N de capteurs de pression couplés au réseau de communication privé numérique et à la deuxième liaison de communication au niveau de l'outil (170), chacun de la pluralité de capteurs de pression pouvant mesurer la pression dans une chambre à vide d'un outil de traitement.

13. Système de régulation de pression selon la revendication 12, dans lequel le nombre N de capteurs de pression est variable.

14. Système de régulation de pression selon la revendication 12, dans lequel le réseau de communication privé numérique peut communiquer les signaux entre le capteur et le régulateur par transmission par paquets à des intervalles temporels réguliers.

15. Système comprenant : un outil comprenant une chambre à vide, un capteur de pression (130) pouvant mesurer la pression dans ladite chambre à vide, un régulateur de pression (140) pouvant réguler la pression dans ladite chambre à vide, et un régulateur d'outil pouvant produire des signaux de régulation d'outil, comprenant au moins un signal fournissant une valeur de consigne de pression pour la chambre de traitement sous vide ; **caractérisé par** :
un réseau de communication privé numérique (150) entre le capteur de pression (130) et le régulateur de pression (140), pouvant assurer un retour d'information de capteur en boucle fermée, comprenant la transmission de signaux de mesure de pression du capteur (130) au régulateur (140) essentiellement sans interférence de tout autre réseau ;
une première liaison de communication au niveau de l'outil (180), distincte et isolée du réseau de communication (150), pouvant fournir des signaux de consigne de l'outil (120) au régulateur (140) ; et
une deuxième liaison de communication au niveau de l'outil (170), distincte et isolée du réseau de communication (150) et distincte de la première liaison de communication au niveau de l'outil (180), pouvant fournir des informations de diagnostic de système entre l'outil et le capteur ; dans lequel le régulateur de pression réagit aux mesures de pression effectuées par le capteur de pression et communiquées au régulateur de pression sur le réseau de communication numérique, afin de réguler la pression dans la chambre à vide et maintenir ainsi la pression dans la chambre à vide au niveau d'une valeur de consigne de pression reçue de l'outil de traitement.

16. Méthode de communication entre une chambre à vide d'un outil, un capteur de pression (130) et un régulateur de pression (140), afin de réguler la pression dans la chambre à vide de l'outil, la méthode étant **caractérisée par** les étapes suivantes :
mesure de la pression dans la chambre à vide et transmission d'un signal de mesure de pression sur un réseau de communication privé numérique (150) ;
réception, en provenance de l'outil, d'un signal représentant une valeur de consigne de pression pour la chambre à vide sur une liaison de communication distincte et isolée du réseau de communication privé numérique ;
régulation, par le régulateur de pression, de la pression dans la chambre à vide en réponse à la mesure de pression et à la valeur de consigne de pression reçues, afin de maintenir la pression dans la chambre à vide à la valeur de consigne de pression ; et
fourniture d'informations de diagnostic de système sur une deuxième liaison de communication privée (170) distincte de la liaison de communication privée entre le capteur et l'outil.
